Europäisches Patentamt

European Patent Office

Office européen des brevets

(11) Publication number: **0 102 241**

**B1**

## EUROPEAN PATENT SPECIFICATION

(45) Date of publication of patent specification: **07.06.89**

(21) Application number: **83304927.3**

(22) Date of filing: **25.08.83**

(51) Int. Cl.⁴: **G 01 D 5/36,** G 01 P 13/04, H 03 M 1/22, G 01 D 5/245

(54) Optical rotary encoder.

(30) Priority: 31.08.82 JP 152014/82
31.08.82 JP 132576/82 u

(43) Date of publication of application:
07.03.84 Bulletin 84/10

(45) Publication of the grant of the patent:
07.06.89 Bulletin 89/23

(84) Designated Contracting States:
DE FR GB IT

(56) References cited:
GB-A-2 070 766
US-A-4 224 514

ARCHIV FÜR TECHNISCHES MESSEN UND
INDUSTRIELLE MESSTECHNIK, vol. 332,
September 1963, pages R113-R119, Munich,
DE; W. PABST: "Digitale Lagemessung an
Arbeitsmaschinen"

(73) Proprietor: SHARP KABUSHIKI KAISHA
22-22 Nagaike-cho Abeno-ku
Osaka 545 (JP)

(72) Inventor: Ebina, Kiyoshi
42-403 Higashikidera 1-chome
Nara-shi Nara-ken (JP)
Inventor: Nakao, Kazuhiro
10-6 Horenminami-machi
Nara-shi Nara-ken (JP)
Inventor: Tani, Zempei
2-8-33 Kishi-cho
Tondabayashi-shi Osaka-fu (JP)

(74) Representative: Wright, Peter David John et al
R.G.C. Jenkins & Co. 26 Caxton Street
London SW1H 0RJ (GB)

Courier Press, Leamington Spa, England.

## Description

The present invention relates to an optical rotary encoder for detecting the angular position and velocity of a rotating wheel.

An optical rotary encoder has been developed, which includes a slit plate secured to the shaft of a rotating wheel. A light emitting element and a plurality of light responsive elements are disposed so that the light beam emitted from the light emitting element toward the light responsive elements is interrupted by the slit plate. The slit plate is provided with a plurality of circumferentially aligned slits so that the light responsive elements periodically receive the light beam through the slits as the slit plate rotates in unison with the rotation of the shaft of the rotating wheel. Output signals derived from the light responsive elements are applied to a detection circuit for determining the angular position and velocity of the rotating wheel.

The conventional optical encoder includes at least two light responsive elements, which are offset from each other in the tangential direction by a distance equal to one half of the width of a slit, and are spaced from each other in the radial direction by a predetermined distance. Because of the displacement in the radial direction, it is difficult to adjust the levels of the output signals from the two light responsive elements. Furthermore, the light responsive elements occupy a considerably large space, which results in enlargement of the optical rotary encoder.

An example of an optical encoder is disclosed in US Patent No. 4,224,514, "OPTICAL ENCODER", issued on September 23, 1980. The encoder disclosed in US Patent 4,224,514 ensures accurate detection. However, the encoder disclosed in this patent requires two pairs of photosensors, each pair including two photosensors separated from each other in the radial direction. Therefore, the encoder of US Patent 4,224,514 occupies a relatively large space. Furthermore, the signal level adjustment is difficult.

In order to compensate for variations in the light beam intensity emitted from the light emitting element, in the conventional optical encoder, another light responsive element is disposed at a position which is suitable for continuously receiving the light beam emitted from the light emitting element without being interrupted by the slit plate. An output signal derived from this light responsive element is used to determine a reference level. This additional light responsive element further enlarges the optical encoder.

Furthermore, in the conventional optical encoder, the detection circuit is discrete from the substrate of the light responsive elements. Therefore, the system requires a cable for transmitting the output signals derived from the light responsive elements to the detection circuit. The cable increases the size of the system and creates noise in the output signals derived from the light responsive elements.

According to the invention there is provided an optical rotary encoder comprising:
· a rotary light interruption member secured to a rotary shaft and having a plurality of light transparent regions distributed regularly around its axis of rotation with a pitch P, the encoder further comprising four photosensors arranged to receive light transmitted via said light transparent regions,
detection circuit means for determining the angular position and velocity of said rotary shaft in accordance with output signals derived from said photosensors, characterised in that the photosensors are disposed in succession around the axis of rotation with a pitch of $\frac{1}{4}$P.

In order that the present invention may be better understood a detailed description is given hereinbelow, of an embodiment thereof, by way of example, with reference to the accompanying drawings in which:

Figure 1 is a schematic plan view of an essential part of a conventional optical rotary encoder;

Figure 2 is a schematic plan view of an essential part of an optical rotary encoder according to the present invention;

Figure 3 is a side view of an optical rotary encoder according to the present invention;

Figure 4 is a plan view of an essential part of the optical rotary encoder of Figure 3;

Figure 5 is a waveform chart for explaining an operational mode of the optical rotary encoder of Figures 2, 3 and 4;

Figure 6 is a circuit diagram of a detection circuit included in the optical rotary encoder of Figure 3; and

Figure 7 is a waveform chart for explaining another operational mode of the optical rotary encoder of Figure 3.

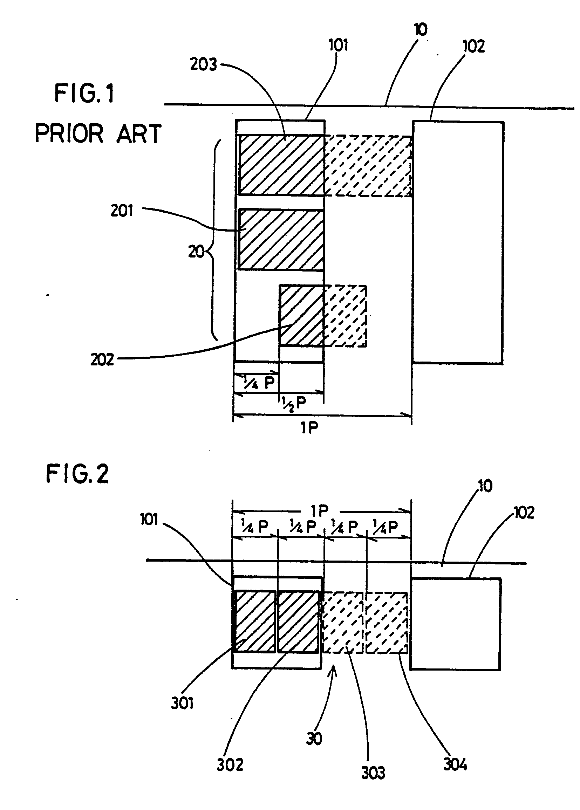

Figure 1 shows an example of the arrangement of photodiodes in a conventional optical rotary encoder. The optical rotary encoder, generally includes a slit plate 10 mounted on a rotating shaft. The slit plate 10 is provided with a plurality of circumferentially aligned slits 101, 102, - - -. A light emitting element (not shown in Figure 1) is disposed at one side of the slit plate 10. A plurality of photodiodes 20 are disposed at the opposite side of the slit plate 10 so that the photodiodes 20 periodically receive the light beam emitted from the light emitting element as the slit plate 10 rotates. Output signals derived from the photodiodes 20 are applied to a detection circuit to determine the angular position and velocity of the rotating shaft.

The photodiodes 20 in the conventional optical rotary encoder include a first photodiode 201 and a second photodiode 202, which are offset from each other in the tangential direction by a distance equal to one half of the width of the slit 101 (102, - - -) so as to develop output signals, one signal leading or lagging the other by 90° depending on the direction of rotation of the shaft. The photodiodes 20 further include a third photodiode 203 for compensating for variations in the intensity of the light beam emitted from the light emitting element. That is, the third photodiode 203 functions as a monitor sensor. The locations of the first through third photodiodes 20 are precisely determined by a mask disposed on the light receiving surface.

The conventional optical rotary encoder of the type shown in Figure 1 occupies a considerably large area because the photodiodes 20 are separated from each other in the radial direction of the slit plate 10. Furthermore, accurate detection is ensured only when the locations of the first and second photodiodes 201 and 202 are precisely adjusted with respect to the location of the slit 101 (102, - - -) on the slit plate 10. Moreover, even when the first and second photodiodes 201 and 202 have the same size, the amount of the light beam impinging on the first photodiode 201 is greater than that impinging on the second photodiode 202 because the two photodiodes 201 and 202 are aligned along the radial direction of the elongated slit 101 (102, - - -). This complicates the adjustment of the signal level from the first and second photodiodes 201 and 202.

Figure 2 shows the arrangement of photodiodes in an optical rotary encoder according to the present invention. Elements corresopnding to those of Figure 1 are indicated by like numerals.

Four photodiodes 30 are aligned in the tangential direction of the slit plate 10 within one pitch of the slits 101, (102, - - -). More specifically, the four photodiodes 30 are aligned with the interval of $\frac{1}{4}$ pitch, and the four photodiodes 30 are formed on a common single semiconductor substrate and are electrically separated from each other. That is, the four photodiodes 30 comprise a first photodiode 301, a second photodiode 302, a third photodiode 303 and a fourth photodiode 304.

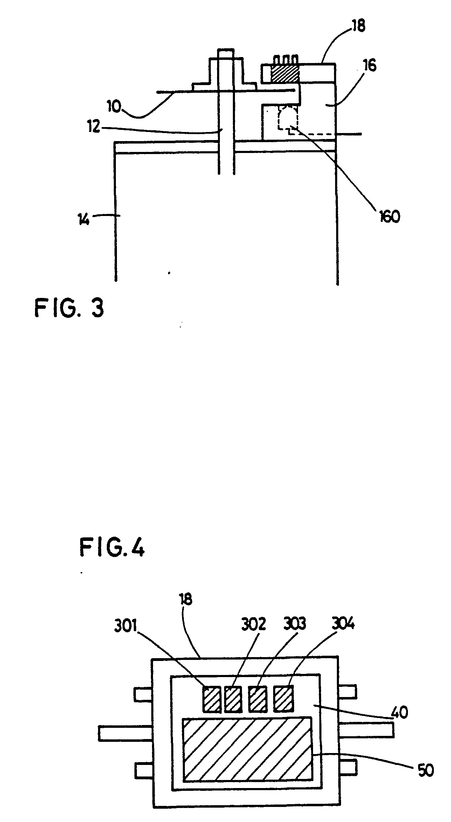

Figure 3 shows schematically the construction of optical rotary encoder of the present invention. Elements corresponding to those of Figure 2 are indicated by like numerals. The slit plate 10 is secured to a rotating shaft 12 of a motor 14. The optical rotary encoder of the present invention includes a light emitting section 16 and a light responsive section 18, which, in combination, substantially sandwich the slit plate 10. The light emitting section 16 includes a light emitting diode 160. The light responsive section 18 includes the above-mentioned four photodiodes 30.

Figure 4 schematically shows the light responsive section 18. As already discussed above, the first through fourth photodiodes 301, 302, 303 and 304 are formed on a common single semiconductor substrate 40. A detection circuit 50, to which the output signals of the first through fourth photodiodes 301, 302, 303 and 304 are applied, is formed on the common single semiconductor substrate 40.

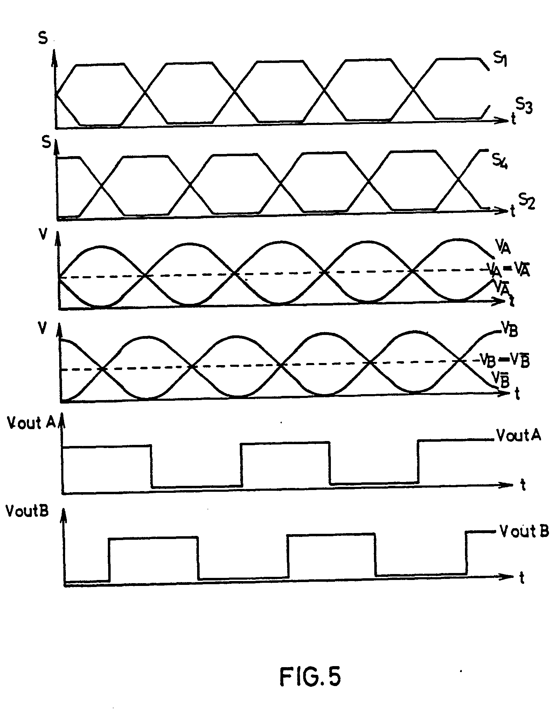

In response to the rotation of the slit plate 10, each of the photodiodes 301, 302, 303 and 304 is periodically exposed to the light beam emitted from the light emitting diode 160. The actual area $S_1$ of the light receiving surface of the first photodiode 301 varies as shown in Figure 5. Similarly, the actual areas $S_2$, $S_3$ and $S_4$ of the light receiving surfaces of the second, third and fourth photodiodes 302, 303 and 304 vary, respectively, as shown in Figure 5. Since the four photodiodes 30 are aligned with an interval of $\frac{1}{4}$ pitch, the variations of the actual areas of the light receiving surfaces are offset by $\frac{1}{4}$ pitch. More spefically, the variation of the actual area $S_1$ of the first photodiode 301 leads or lags the variation of the actual area $S_2$ of the second photodiode 302 by 90° depending on the direction of rotation of the shaft 12. The variation of the actual area $S_1$ of the first photodiode 301 leads or lags the variation of the actual area $S_3$ of the third photodiode 303 by 180° depending on the direction of the rotation of the shaft 12. The variation of the actual area $S_1$ of the first photodiode 301 leads or lags the variation of the actual area $S_4$ of the fourth photodiode 304 by 270° depending on the direction of rotation of the shaft 12.

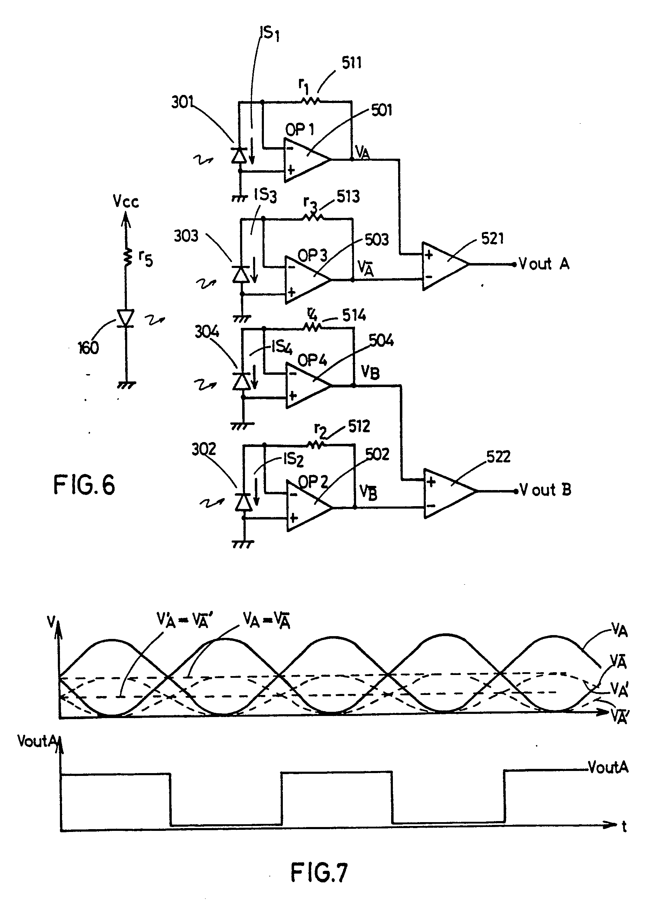

Figure 6 shows the construction of the detection circuit 50. In response to the variations of the actual areas $S_1$ through $S_4$, each of the photodiodes 301 through 304 generates an opto-electric current $IS_1$, $IS_2$, $IS_3$ and $IS_4$, respectively, which is proportional to the actual areas $S_1$ through $S_4$ of the light receiving surfaces. Each of the thus generated opto-electric currents $IS_1$, $IS_2$, $IS_3$ and $IS_4$ is applied to one of the operational amplifiers 501 (OP1), 502 (OP2), 503 (OP3) and 504 (OP4). When the resistance value of a feedback resistor 511 of the operational amplifier 501 (OP1) is $r_1$, the output voltage $V_A$ of the operational amplifier 501 (OP1) is given by the equation:—

$$V_A = r_1 \times IS_1$$

When the resistance value of a feedback resistor 512 of the operational amplifier 502 (OP2) is $r_2$, the output voltage $V_{\bar{B}}$ of the operational amplifier 502 (OP2) is given by the equation:—

$$V_{\bar{B}} = r_2 \times IS_2$$

The output voltage $V_A$ leads or lags the output voltage $V_{\bar{B}}$ by 90° depending on the direction of the rotation of the shaft 12 as shown in Figure 5.

Similarly the output voltages $V_{\bar{A}}$ and $V_B$ of operational amplifiers 503 (OP3) and 504 (OP4) respectively, are given by the equations:—

$$V_{\bar{A}} = r_3 \times IS_3 \quad \text{and} \quad V_B = r_4 \times IS_4$$

where $r_3$ and $r_4$ are the values of the feedback resistances 513 and 514 respectively.

The output voltage $V_A$ of the operation amplifier 501 (OP1) leads or lags the output voltage $V_A$ of the operation amplifier 503 (OP3) by 180°, depending on the direction of the rotation of the shaft 12, and also leads or lags the output voltage $V_B$ of the operation amplifier 504 (OP4) by 270°, depending on the direction of the rotation of the shaft 12, as shown in Figure 5.

The output voltage $V_A$ of the operational amplifier 501 (OP1), and the output voltage $V_{\bar{A}}$ of the operational amplifier 503 (OP3) are applied to a first comparator 521. When the level of the output voltage $V_A$ is greater than the level of the output voltage $V_{\bar{A}}$ an output signal VoutA of the first comparator 521 bears the logic high as shown in Figure 5. If the output voltage $V_A$ is lower than the output voltage $V_{\bar{A}}$, the output signal VoutA bears the logic low as shown if Figure 5. The output voltage $V_B$ of the operation amplifier 504 (OP4), and the output voltage $V_{\bar{B}}$ of the operation amplifier 502 (OP2) are applied to a second comparator 522. When the level of the output voltage $V_B$ is higher than the level of the output voltage $V_{\bar{B}}$, the output signal VoutB of the second comparator 522 bears the logic low as shown in Figure 5.

Alternatively, when the output voltage $V_B$ is lower than the output voltage $V_{\bar{B}}$ of the operation amplifier 502 (OP2), the output signal VoutB bears the logic low as shown in Figure 5. The thus obtained output signals VoutA and VoutB are offset by 90°, and are utilized to obtain information regarding the angular position and velocity of the rotating shaft 12.

When the intensity of the light beam emitted from the light emitting diode 160 becomes small, the voltage level of the output voltages $V_A$, $V_{\bar{A}}$, $V_B$ and $V_{\bar{B}}$ becomes small. Figure 7 shows the reduced output voltages $V_{A'}$ and $V_{\bar{A}'}$. It will be clear from Figure 7 that the output signals VoutA and VoutB do not change even when the intensity of the light beam emitted from the light emitting diode 160 varies. That is, the detection circuit of Figure 6 functions do compensate for the variations in the characteristics of the light emitting element and the light responsive elements.

The invention being thus described, it will be obvious that the same may be varied in many ways. Such variations are not to be regarded as a departure from the scope of the invention as defined in the claims. There are described above novel features which the skilled man will appreciate give rise to advantages.

## Claims

1. An optical rotary encoder comprising:
a rotary light interruption member (10) secured to a rotary shaft (12) and having a plurality of light-transparent regions (101, 102, etc.) distributed regularly around its axis of rotation with a pitch P, the encoder further comprising four photosensors (30) arranged to receive light transmitted via said light-transparent regions (101, 102, etc.),
detection circuit means (50) for determining the angular position and velocity of said rotary shaft (12) in accordance with output signals derived from said photosensors (30), characterized in that the photosensors (30) are disposed in succession around the axis of rotation with a pitch of ¼P.

2. An encoder as claimed in claim 1, wherein the photosensors (30) are all positioned at substantially the same radial distance from the axis of rotation.

3. The optical rotary encoder of claim 1 or claim 2, wherein said four photosensors (30) are formed on a common single semiconductor substrate (40).

4. The optical rotary encoder of claim 3, wherein said detection circuit means (50) is also formed on said common single semiconductor substrate (40).

5. An optical rotary encoder comprising:
a slit plate (10) secured to a rotary shaft (12), said slit plate having a plurality of slits (101, 102, etc.) circumferentially spaced with a predetermined pitch P;
a light emitting diode (160) disposed to one side of said slit plate (10);
four photodiodes (301, 302, 303, 304), which are electrically separated from each other, formed on a single semi-conductor substrate (40), disposed to the opposite side of said slit plate (10); and
detection circuit means (50) for determining the angular position and velocity of said rotary shaft (12) in accordance with output signals derived from the four photodiodes (301, 302, 303, 304), said detection circuit (50) comprising four amplifying circuits (501, 502, 503, 504) each connected to a respective one of the photodiodes (301, 302 etc.), a first comparator (521) for comparing the output signal levels obtained from the amplifying circuits (501, 503) connected to the first and third photodiodes (301, 303), and a second comparator (522) for comparing the output signal levels obtained from the amplifying circuits (502, 504) connected to the second and fourth photodiodes (302, 304),
characterised in that said four photodiodes (301, 302, 303, 304) are all disposed at substantially the same radial distance from the axis of rotation of the shaft (12), and are spaced apart circumferentially with a predetermined interval corresponding to one quarter of the predetermined pitch P.

6. The optical rotary encoder of claim 5, wherein said detection circuit means (50) is also formed on said single semiconductor substrate (40).

## Patentansprüche

1. Optischer Drehkodierer mit:
—einem fest mit einer Drehwelle (12) verbundenen Lichtunterbrecher (10), der um seine Drehachse in gleichmäßig Teilung P angeordnete lichtdurchlässige Bereiche (102, 102, usw.) aufweist,
—vier Photosensoren (30), die das durch die lichtdurchlässigen Bereiche (101, 102, usw.) hindurchtretende Licht aufnehmen,
—einer Detektorschaltung (50) zum Feststellen der Winkelstellung und der Geschwindigkeit der Drehwelle (12) mittels der Ausgangssignale der Photosensoren (30) dadurch gekennzeichnet, daß die Photosensoren (30) um die Drehachse mit einer Teilung von ¼P angeordnet sind.

2. Drehkodierer nach Anspruch 1, dadurch gekennzeichnet, daß die Photosensoren (30) alle im wesentlichen den gleichen radialen Abstand zur Drehachse aufweisen.

3. Drehkodierer nach Anspruch 1 oder 2, dadurch gekennzeichnet, daß die vier Photosensoren (30) auf einem einzigen, gemeinsamen Halbleitersubstrat (40) ausgebildet sind.

4. Drehkodierer nach Anspruch 3, dadurch gekennzeichnet, daß die Detektorschaltung (50) ebenfalls auf dem einzigen, gemeinsamen Halbleitersubstrat (40) ausgebildet ist.

5. Optischer Drehkodierer mit:
—einer Schlitzplatte (10), die an einer Drehwelle (12) befestigt ist und mehrere in Umfangsrichtung mit einer Teilung P voneinander beabstandete Schlitze (101, 102, usw.) aufweist;
—einer Leuchtdiode (160), die auf einer Seite der Schlitzplatte (10) angeordnet ist;
—vier Photodioden (301, 302, 303, 304), die elektrisch voneinander getrennt, auf einem einzigen Halbleitersubstrat (40) ausgebildet und an der engegengesetzten Seite der Schlitzplatte angeordnet sind; und mit
—einer Detektorschaltung (50) zum Feststellen der Winkelstellung und Geschwindigkeit der Drehwelle (12) mittels der Ausgangssignale der vier Photodioden (301, 302, 303, 304),
—vier jeweils an eine zugeordnete Photodiode (301, 302, usw.) angeschlossenen Verstärkerschaltungen (501, 502, 503, 504),
—mit einem ersten Komparator (521) zum Vergleichen der Ausgangssignalpegel der Verstärkerschaltungen (501, 503), die mit der ersten bzw. dritten Photodiode (301, 303) verbunden sind, und mit
—einem zweiten Komparator (522) zum Vergleichen der Ausgangssignalpegel der Verstärkerschaltungen (502, 504), die an die zweite bzw. vierte Photodiode (302, 304) angeschlossen sind, dadurch gekennzeichnet, daß die vier Photodioden (301, 302, 303, 304) alle im wesentlichen im gleichen radialen Abstand zur Drehachse der Drehwelle (12) angeordnet sind und in Umfangsrichtung mit einem gegenseitigen Abstand, der ein Viertel der vorgegebenen Teilung P entspricht, angeordnet sind.

6. Drehkodierer nach Anspruch 5, dadurch gekennzeichnet, daß die Detektorschaltung (50) ebenfalls auf dem einzigen Halbleitersubstrat (40) ausgebildet ist.

**Revendications**

1. Codeur optique rotatif comprenant:
un élément rotatif (10) d'interruption de la lumière, fixé à un arbre rotatif (12) et comportant une pluralité de parties transparentes (101, 102, etc) réparties de façon régulière autour de son axe de rotation selon un pas P, le codeur comprenant en outre quatre photocapteurs (30) disposés de manière à recevoir une lumière transmise par l'intermédiaire desdites parties transparentes (101, 102, etc),
des moyens (50) formant circuit de détection servant à déterminer la position angulaire et la vitesse dudit arbre rotatif (12) conformément à des signaux de sortie délivrés par lesdits photocapteurs (30),
caractérisé en ce que les photocapteurs (30) sont disposés successivement autour de l'axe de rotation selon un pas égal à ¼ P.

2. Codeur selon la revendication 1, dans lequel les photocapteurs (30) sont tous disposés sensiblement à la même distance radiale de l'axe de rotation.

3. Codeur optique rotatif selon la revendication 1 ou 2, dans lequel quatre photocapteurs (30) sont formés sur un substrat semiconducteur unique commun (40).

4. Codeur optique rotatif selon la revendication 3, dans lequel lesdits moyens (50) formant circuit de détection sont également formés sur ledit substrat semiconducteur unique commun (40).

5. Codeur optique rotatif comprenant:
une plaque à fentes (10) fixées à un arbre rotatif (12) et comportant une pluralité de fentes (101, 102, etc) espacées circonférentiellement selon un pas (P) prédéterminé;
une diode photoémissive (160) disposée sur une face de ladite plaque à fentes (10);
quatre photodiodes (301, 302, 303, 304) séparées électriquement les unes des autres, formées sur un substrat semiconducteur unique (40) et disposées sur la face opposée de ladite plaque à fentes (10); et
des moyens (50) formant circuit de détection, servant à déterminer la position angulaire et la vitesse dudit arbre rotatif (12) conformément à des signaux de sortie délivrés par les quatre photodiodes (301, 302, 303, 304), ledit circuit de détection (52) comprenant quatre circuits amplificateurs (501, 502, 503, 504) raccordés chacun à l'une respective des photodiodes (301, 302, etc), un premier comparateur (521) servant à comparer les niveaux des signaux de sortie obtenus à partir des circuits amplificateurs (501, 503) raccordés aux première et troisième photodiodes (301, 303), et un second comparateur (522) servant à comparer les niveaux des signaux de sortie délivrés par les circuits amplificateurs (502, 504) raccordés aux seconde et quatrième photodiodes (302, 304), caractérisé en ce que lesdites quatre photodiodes (301, 302, 303, 304) sont toutes disposées sensiblement à la même distance radiale de l'axe de rotation de l'arbre (12) et sont espacées circonférentiellement en étant séparées par un intervalle prédéterminé correspondant à un quart du pas P prédéterminé.

6. Codeur optique rotatif selon la revendication 5, dans lequel lesdits moyens (5) formant circuit de détection sont également formés sur ledit substrat semiconducteur unique (40).

FIG.1
PRIOR ART

203
101
10
102
201
20
202

¼ P
½ P
1P

FIG.2

1P
¼ P   ½ P   ¼ P   ¼ P

101
10
102
301
302
303
304
30

1

EP 0 102 241 B1

FIG. 3

FIG.4

2

FIG.5

FIG.6

FIG.7